# EUROPÄISCHE PATENTSCHRIFT

(11) **EP 2 697 888 B1**
(45) Veröffentlichungstag und Bekanntmachung des Hinweises auf die Patenterteilung: **04.09.2019**
(21) Anmeldenummer: 11714983.1
(22) Anmeldetag: 15.04.2011
(51) Int. Cl.: H02J 13/00

(54) **VERFAHREN ZUR BESTIMMUNG DER TOPOLOGIE EINES NIEDERSPANNUNGSNETZES**
METHOD FOR DETERMINING THE TOPOLOGY OF A LOW-VOLTAGE DISTRIBUTION GRID
MÉTHODE DE DÉTERMINATION DE LA TOPOLOGIE D'UN RÉSEAU DE DISTRIBUTION BASSE TENSION

(43) Veröffentlichungstag der Anmeldung: 19.02.2014
(73) Patentinhaber: Siemens Aktiengesellschaft, 80333 München (DE)
(72) Erfinder: KUSSYK, Jaroslaw, A-1170 Wien (AT)
(74) Vertreter: Maier, Daniel Oliver
(86) Internationale Anmeldenummer: PCT/EP2011/056020
(87) Internationale Veröffentlichungsnummer: WO 2012/139658

(56) Entgegenhaltungen:
- EP-A2- 2 246 955
- WO-A1-2009/061291
- WO-A2-2010/027421
- US-A1- 2004 130 837
- US-A1- 2007 005 277
- US-A1- 2009 300 034

## Beschreibung

Mit der zunehmenden Dezentralisierung der Energieerzeugung, beispielsweise durch Fotovoltaikanlagen oder kleine Kraft-Wärme-Kopplungsanlagen in privaten Haushalten, verändert sich die Art der Nutzung der Verteilnetze von einer zentralisierten Stromverteilung (von einer oder mehreren Transformatorstationen in Richtung zum Energieverbraucher) in eine zumindest zeitweise dezentrale Stromverteilung (z. B. von einem Haushalt zu einem anderen Haushalt oder sogar von mehreren privaten Energieerzeugern in Richtung Transformatorstation bzw. in Richtung Mittelspannungsnetz).

Um die Überwachung der Stromverteilung und der Spannungsqualität sowie eine effiziente Steuerung der Energieverteilnetze zu gewährleisten, ist es nötig, eine möglichst genaue Kenntnis über den Betriebszustand der Verteilnetze, deren Topologie sowie die Strombelastung der einzelnen Verteilnetzleitungen zu haben.

Die Planung bzw. der Ausbau der Niederspannungsverteilnetze fand oft vor vielen Jahren oder sogar Jahrzehnten statt. Während der nachfolgenden Zeit erfolgte eine weitere evolutionäre Entwicklung der Verteilnetze, welche die Topologie der Verteilnetze durch einen Zu-, Um- und Ausbau veränderte. Die Dokumentation über die Topologie der Niederspannungsverteilnetze wurde oft nicht vollständig aktualisiert. Dazu kommt der Umstand, dass innerhalb der Niederspannungsverteilnetze eine Vielzahl an Schalteinrichtungen (schaltbaren Trennstellen) vorhanden ist, die beispielsweise zur Netzumschaltung bei Servicearbeiten dienen können. Häufig kommt es vor, dass der Schaltzustand dieser Schalteinrichtungen nicht bekannt ist.

Die beschriebene Praxis beim Betrieb der Niederspannungsverteilnetze hat zur Folge, dass die Topologiekenntnis lückenhaft ist und insbesondere der Schaltzustand von Trennstellen oft unbekannt ist. Erschwerend kann es dazu kommen, dass in einem öffentlichen Stromversorgungsnetz zumindest temporär unregistrierte Netzanschlüsse vorgenommen werden können, die durch eine Stromrückspeisung oder durch einen Strombezug die Netztopologieüberwachung stören können.

Um die oben beschriebene Problematik in den Griff zu bekommen, wird in der Praxis die Topologie der Niederspannungsverteilnetze heutzutage manuell erfasst und in ein sogenanntes geografisches Informationssystem (GIS) eingegeben. Ein solches geografisches Informationssystem bedarf jedoch einer stetigen Pflege, um den Datenbestand aktuell zu halten.

Aus den Schriften WO 2009/061291 A1 und US 2007/005277 A1 sind beispielsweise ein Verfahren zum automatischen Ermitteln, auf welche Weise eine Vielzahl von Einheiten direkt oder indirekt in einem Überwachungssystem verbunden sind, bzw. ein Verfahren zum automatischen Erlernen eines hierarchischen Layouts eines Überwachungssystems bekannt. Dabei kann das jeweilige Verfahren dazu genutzt werden, um beispielsweise eine verbrauchte Leistungsmenge mit einer gelieferten Leistungsmenge in einem Energieverteilungssystem abzustimmen und gegebenenfalls zur Lösung von Problemen oder zur Anpassung des Energieverteilnetzes zu nutzen.

Aus der Schrift US 2009/0300034 A1 ist weiterhin ein Verfahren und ein System zum Konvertieren von numerischen Infrastrukturdaten eines Überwachungssystems in eine Speicherformat bekannt, wobei die Daten zu einem automatischen Datenanordnungssystem und zu einem Hierarchieklassifizierungssystem übertragen und von diesen entsprechend ausgewertet werden.

Weiterhin beschreibt die Schrift EP 2 246 955 A2 eine Vorrichtung zum Schalten und Managen von elektrischer Energie und elektrischen Netzen. Diese Vorrichtung weist einen Eingangs- und Ausgangsseite mit jeweils einer Vielzahl an so genannten Ports auf. Die Weiterleitung von Energie von einem Eingangsport zu einem Ausgangsport wird über eine Kontrollmatrix durchgeführt, wobei jeder Port ein elektronisches System mit Speicher für eine Parameterspeicherung aufweist, und die gespeicherten Parameter an eine Steuereinheit übertragen und mit vorgegebenen Vergleichswerten verglichen werden. Bei Abweichungen können dann entsprechende Maßnahmen gesetzt werden.

Der Erfindung liegt die Aufgabe zugrunde, ein gegenüber dem Stand der Technik verbessertes und effizienteres Verfahren zum Ermitteln von Topologieinformationen über ein elektrisches Niederspannungsverteilnetz anzugeben, durch welches ohne aufwändige Datenübertragung und -auswertung Auswertungsfehler geringgehalten und relativ genaue Topologieinformationen ermittelt werden.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist ein Verfahren vorgesehen, bei dem
(a) eine Gruppe von mindestens zwei an unterschiedlichen Stellen des Niederspannungsverteilnetzes angeordneten Strommesseinrichtungen ausgewählt wird,
(b) mit den Strommesseinrichtungen jeweils der Strom unter Bildung eines Strommesswerts gemessen wird, wobei als Stromwerte der Grundschwingung des durch die jeweilige Strommesseinrichtungen fließenden Stromes gebildet wird, und wobei den Strommesseinrichtungen ein Startzeitpunkt und eine Zeitdauer einer Messung der Stromwerte mittels eines Startsignals vorgegeben wird;
(c) die Strommesswerte unter Berücksichtigung der Stromflussrichtung unter Bildung einer Stromsumme addiert werden und
(d) eine Topologieinformation gebildet wird, die angibt, dass die Strommesseinrichtungen einen last- und quellenfreien Abschnitt des Niederspannungsverteilnetzes elektrisch abgrenzen, wenn die Stromsumme einen vorgegebenen Schwellenwert betragsmäßig unterschreitet.

Ein wesentlicher Vorteil des erfindungsgemäßen Verfahrens besteht darin, dass dieses automatisch, beispielsweise rechnergestützt, durchgeführt werden kann. Ist eine Vielzahl an Strommesseinrichtungen vorhanden und liegt demgemäß eine Vielzahl an Strommesswerten vor, so kann durch eine automatisierte Auswertung der Strommesswerte der vorhandenen Stromeinrichtungen festgestellt werden, welche Teilgruppen der Strommesseinrichtungen einen last- und quellenfreien Abschnitt des Niederspannungsverteilnetzes elektrisch abgrenzen, und zwar auch ohne vorherige Kenntnis des inneren Aufbaus und der inneren Verschaltung des Niederspannungsverteilnetzes. Die Topologieinformationen können also nachträglich allein anhand der vorliegenden Strommesswerte gebildet werden. Mit anderen Worten ist eine Topologieerfassung ohne Vorkenntnisse möglich. Die Topologieinformationen können in vorteilhafter Weise nachfolgend zur weiteren Steuerung des Niederspannungsverteilnetzes herangezogen werden. Beispielsweise kann in einer Leitstelle ein topologisches Abbild des Niederspannungsverteilnetzes erstellt und zur weiteren Steuerung des Niederspannungsverteilnetzes herangezogen werden. So ermöglichen es die Topologieinformationen beispielsweise, eine nachträgliche Topologieänderung zu detektieren: Überschreitet nämlich die Stromsumme eines zuvor quellen- und lastenfreien Abschnitts des Niederspannungsverteilnetzes später betragsmäßig den vorgegebenen Schwellenwert, so steht fest, dass es zu einer Veränderung der Topologie gekommen ist und die Topologieinformationen aktualisiert werden müssen. Eine Topologieänderung kann beispielsweise dadurch hervorgerufen werden, dass in einen zuvor last- und quellenfreien Abschnitt ein Strom eingespeist wird oder aus einem zuvor last- und quellenfreien Abschnitt ein Strom entnommen wird; eine solche Topologieänderung kann beispielsweise dadurch erfolgen, dass ein innerhalb des zuvor quellen- und lastenfreien Abschnitts vorhandener offener Trennschalter - aus welchen Gründen auch immer -geschlossen wird und somit ein zusätzlicher Stromfluss ermöglicht wird.

Um die Topologie des Niederspannungsverteilnetzes in einfacher Weise möglichst vollständig zu erfassen, kann beispielsweise vorgesehen werden, dass
(e) im Falle, dass in Schritt (d) keine Topologieinformation gebildet worden ist, eine neue Gruppe von mindestens zwei an unterschiedlichen Stellen des Niederspannungsverteilnetzes angeordneten Strommesseinrichtungen ausgewählt wird,
(f) mit den Strommesseinrichtungen der neuen Gruppe der Strom jeweils unter Bildung eines neuen Strommesswerts gemessen wird,
(g) die neuen Strommesswerte unter Berücksichtigung der Stromflussrichtung unter Bildung einer neuen Stromsumme addiert werden,
(h) eine Topologieinformation gebildet wird, die angibt, dass die Strommesseinrichtungen einen last- und quellenfreien Abschnitt des Niederspannungsverteilnetzes elektrisch abgrenzen, wenn die neue Stromsumme den vorgegebenen Schwellenwert betragsmäßig unterschreitet, und
(i) die Schritte (e) bis (h) wiederholt werden, bis eine Topologieinformation gebildet worden ist.

In der beschriebenen Weise kann eine Vielzahl an Strommesseinrichtungsgruppen gebildet werden, um Schritt für Schritt weitere Topologieinformationen zu gewinnen. Beispielsweise können systematisch - zum Beispiel nach einem vorgegebenen Algorithmus - Strommesseinrichtungsgruppen auf der Basis aller möglichen Kombinationen der im Niederspannungsverteilnetz vorhandenen Strommesseinrichtungen gebildet und bezüglich des Über- oder Unterschreitens des Schwellenwerts ausgewertet werden. Die entsprechend erzeugten Topologieinformationen können - wie oben beschrieben - zentral weiterverarbeitet werden.

Gemäß einer besonders bevorzugten Ausgestaltung des Verfahrens ist vorgesehen, dass vor der Auswahl der neuen Gruppe eine weitere Strommesseinrichtung an das elektrische Niederspannungsverteilnetz angeschlossen wird, wobei die weitere Strommesseinrichtung den Strom durch eine zugeordnete Stelle des Niederspannungsverteilnetzes, beispielsweise durch eine Schalteinrichtung des Niederspannungsverteilnetzes, misst, und diese weitere Strommesseinrichtung zu der neuen Gruppe von Strommesseinrichtungen hinzugefügt wird. Bei dieser Ausgestaltung des Verfahrens wird zur automatisierten Erfassung der Topologieinformationen in vorteilhafter Weise ein "ergänztes" Niederspannungsverteilnetz gebildet, bei dem an für die Überwachung der topologischen Eigenschaften des Niederspannungsverteilnetzes wichtigen Stellen - wie beispielsweise Netzleitungsabzweigen, Netzleitungsgabelungen, Netzleitungsknoten oder Netzleitungstrennstellen - zusätzliche Strommesseinrichtungen zum Erfassen des Betriebszustandes des Niederspannungsverteilnetzes eingesetzt werden.

Werden beispielsweise Strommesseinrichtungen vor oder hinter Schalteinrichtungen (schaltbaren Trennstellen) eingefügt, so kann gleichzeitig auch die Schalterstellung erfasst und als Topologieinformation weiterverarbeitet werden.

Als Strommesswerte werden vorzugsweise zeitlich gemittelte Strommesswerte der Grundschwingung des durch die jeweiligen Strommesseinrichtungen fließenden Stromes gebildet.

Wenn zum Betrieb der Strommesseinrichtungen aus dem Niederspannungsverteilnetz Betriebsstrom entnommen wird, so kann der Stromverbrauch der Strommesseinrichtungen in unterschiedlicher Weise berücksichtigt werden: Zum einen ist es möglich, den vorgegebenen Schwellenwert für die Bildung der Topologieinformationen so zu bemessen, dass der Stromverbrauch der Strommesseinrichtungen demgegenüber vernachlässigbar ist; alternativ ist es möglich, den Stromabzweig, der durch die Strommesseinrichtungen gebildet wird, bei der Bildung der last- und quellenfreien Abschnitte mit zu berücksichtigen und den Stromverbrauch der Strommesseinrichtungen durch ein entsprechendes Abfließen von Strom aus dem jeweiligen Abschnitt zu berücksichtigen.

Als zeitlich gemittelte Strommesswerte können beispielsweise zeitlich gemittelte Effektivwerte, zeitlich gemittelte Amplitudenwerte oder zeitlich gemittelte Scheitelwerte der Grundschwingung des Stromes verwendet werden.

Die zeitlich gemittelten Strommesswerte geben vorzugsweise jeweils den für eine vorgegebene Zeitdauer zeitlich gemittelten Wirkstrom und/oder Blindstrom der Grundschwingung des durch die jeweilige Strommesseinrichtung fließenden Stromes an.

Die Erfindung bezieht sich darüber hinaus auf ein Niederspannungsverteilnetz, das eine automatisierte Erfassung der Topologie mittels einer Zentraleinrichtung ermöglicht.

Diesbezüglich ist ein Niederspannungsverteilnetz vorgesehen mit mindestens einer Schalteinrichtung, mindestens einer Strom- und/oder Spannungsmesseinrichtung und einer mit der mindestens einen Strom- und/oder Spannungsmesseinrichtung in Verbindung stehenden Zentraleinrichtung, wobei die mindestens eine Strom- und/oder Spannungsmesseinrichtung geeignet ist, den durch die mindestens eine Schalteinrichtung fließenden Strom und/oder die an der mindestens einen Schalteinrichtung anliegende Spannung unter Bildung zumindest eines Strom- und/oder Spannungsmesswerts zu messen, und den zumindest einen Strom- und/oder Spannungsmesswert oder ein den Schaltzustand der mindestens einen Schalteinrichtung angebendes Zustandssignal zu der Zentraleinrichtung zu übertragen. Dabei ist die mindestens eine Strommesseinrichtung derart ausgestaltet, dass sie als Strommesswert einen zeitlich gemittelten Strommesswert der Grundschwingung des Stromes bildet, und der mindestens einen Strommesseinrichtung (17a-17e, 16a-16h) ist ein Startzeitpunkt und eine Zeitdauer einer Messung der Stromwerte mittels eines Startsignals vorgebbar.

Bezüglich der Vorteile des erfindungsgemäßen Niederspannungsverteilnetzes sei auf die obigen Ausführungen im Zusammenhang mit dem erfindungsgemäßen Verfahren verwiesen, da die Vorteile des erfindungsgemäßen Niederspannungsverteilnetzes denen des erfindungsgemäßen Verfahrens im Wesentlichen entsprechen. Mit den Strom- und/oder Spannungsmesseinrichtungen können die Schalterstellungen der Schalteinrichtungen erfasst und entsprechende Topologieinformationen gewonnen werden, die sich zur weiteren Steuerung des Verteilnetzes heranziehen lassen.

Auch kann im Falle einer Spannungsmessung im Rahmen der Auswertung der Spannungsmesswerte die Spannungsqualität überwacht werden.

Die Zentraleinrichtung kann eine separate Komponente sein, die mit den Schalteinrichtungen verbunden ist. Als besonders bevorzugt wird es jedoch angesehen, wenn die Zentraleinrichtung einen Bestandteil einer der Strom- und/oder Spannungsmesseinrichtungen bildet.

Gemäß einer besonders bevorzugten Ausgestaltung des Niederspannungsverteilnetzes ist vorgesehen, dass die mindestens eine Strommesseinrichtung derart ausgestaltet ist, dass sie zumindest zwei zeitlich gemittelte Strommesswerte ermittelt und an die Zentraleinrichtung überträgt, von denen ein erster Strommesswert den für eine vorgegebene Zeitdauer gemittelten Wirkstrom der Grundschwingung des Stromes angibt und von denen ein zweiter Strommesswert den für dieselbe vorgegebene Zeitdauer gemittelten Blindstrom der Grundschwingung des Stromes angibt. Mit Hilfe einer Auswertung von Wirkstrom und Blindstrom lässt sich besonders zuverlässig die Topologie des Niederspannungsverteilnetzes bestimmen.

Außerdem wird es als vorteilhaft angesehen, wenn das Niederspannungsverteilnetz eine Gruppe von mindestens zwei Strommesseinrichtungen umfasst, die jeweils einer Stelle des Niederspannungsverteilnetzes zugeordnet sind und geeignet sind, den Strom unter Bildung zumindest eines Strommesswerts zu messen und den Strommesswert zu der Zentraleinrichtung zu übertragen, wobei die Strommesseinrichtungen der Gruppe einen last- und quellenfreien Abschnitt des Niederspannungsverteilnetzes abgrenzen. Eine solche Anordnung der Strommesseinrichtungen ermöglicht es in sehr vorteilhafter Weise, mit Hilfe der Messergebnisse der Strommesseinrichtungen den jeweiligen Betriebszustand des Niederspannungsverteilnetzes korrekt anzugeben.

Die Strommesseinrichtungen einer jeweiligen Gruppe bilden ihre Strommesswerte vorzugsweise synchron, um Auswertungsfehler zu reduzieren. Eine synchrone Messung kann beispielsweise durch externe Triggersignale erzwungen werden; alternativ können die Strommesseinrichtungen auch autark zu vorab festgelegten Zeiten ihre Messungen durchführen.

Im Falle einer zeitlichen Mittelung der Strommesswerte wird es als vorteilhaft angesehen, wenn die Strommesseinrichtungen einer jeden Gruppe ihre Strommesswerte jeweils für dieselbe vorgegebene Zeitdauer zeitlich mitteln.

Mit Blick auf Synchronisierungsfehler wird es als vorteilhaft angesehen, wenn die vorgegebene Zeitdauer, über die eine zeitliche Mittelung erfolgt, größer ist als das Zehnfache des zu erwartenden zeitlichen Synchronisierungsfehlers der Strommesseinrichtungen der jeweiligen Gruppe.

Die Zentraleinrichtung des Niederspannungsverteilnetzes ist vorzugsweise geeignet, zur Bildung von Topologieinformationen das eingangs beschriebene erfindungsgemäße Verfahren auszuführen.

Die Erfindung wird nachfolgend anhand von Ausführungsbeispielen näher erläutert, dabei zeigen beispielhaft:
- Figur 1: ein Ausführungsbeispiel für ein erfindungsgemäßes Niederspannungsverteilnetz, anhand dessen auch das erfindungsgemäße Verfahren beispielhaft erläutert wird;
- Figur 2: einen Teilnetzstrang des Niederspannungsverteilnetzes gemäß Figur 1 näher im Detail und
- Figur 3: das Niederspannungsverteilnetz gemäß Figur 1, nachdem zwei Schalter umgeschaltet worden sind.

In den Figuren werden der Übersicht halber für identische oder vergleichbare Komponenten stets dieselben Bezugszeichen verwendet.

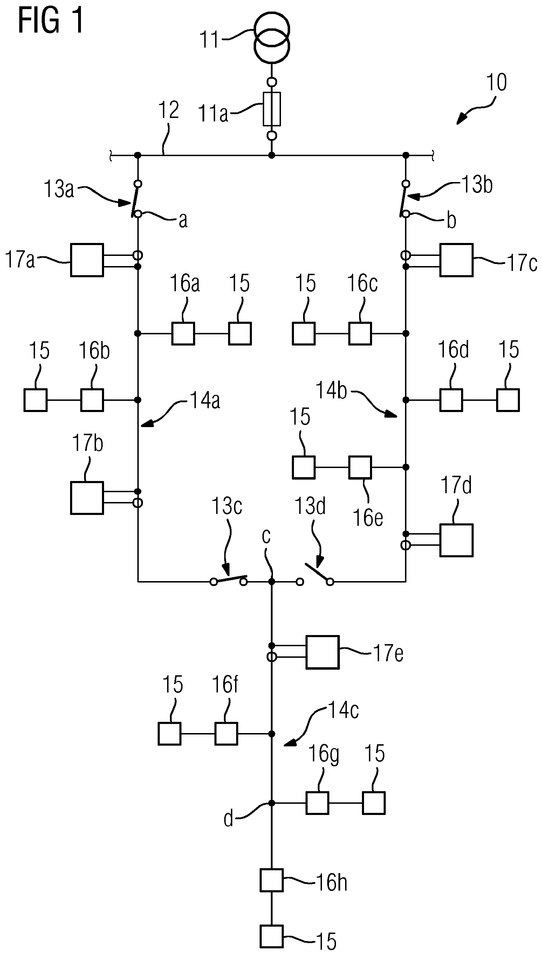

Die Figur 1 zeigt ein Ausführungsbeispiel für ein erfindungsgemäßes Niederspannungsverteilnetz 10, das einen Teilbereich eines Drehstromnetzes darstellt. Das Niederspannungsverteilnetz 10 umfasst einen Netztransformator 11 mit einer Transformatorsicherung 11a, eine Sammelschiene 12 mit Schaltereinrichtungen 13a und 13b (in geschlossener Stellung) sowie Verteilnetzstränge 14a (zwischen den Punkten a und c), 14b (zwischen den Punkten b und c) und 14c (zwischen den Punkten c und d). Die einzelnen Verteilnetzteilnehmer 15 (Energieverbrauchseinrichtungen oder Energieabgabeeinrichtungen) sind mittels Energiezählern 16a bis 16h an das Netz 10 angeschlossen. In der in Figur 1 dargestellten Netztopologie ist der Netzstrang 14c mittels einer geschlossenen Schalteinrichtung 13c mit dem Strang 14a verbunden. Die Schalteinrichtung 13d ist geöffnet, so dass die Stränge 14c und 14b elektrisch getrennt sind.

Zur Überwachung der Netzstränge 14a bis 14c sind im Netz Strommesseinrichtungen 17a bis 17e installiert, welche die Verteilnetztopologie in drei Netzbereiche eingrenzen. Zusätzlich umfassen auch die Energiezähler 16a bis 16h den Strommesseinrichtungen 17a bis 17e entsprechende Komponenten, die - wie weiter unten näher ausgeführt wird - zur Überwachung der Netzstränge 14a bis 14c verwendet werden. In der Figur 1 sind die Netzstränge 14a bis 14c samt allen dazugehörigen Elementen als ein Leitungsbündel dargestellt, das Phasenleitungen L1 bis L3 und den Nullleiter symbolisieren soll.

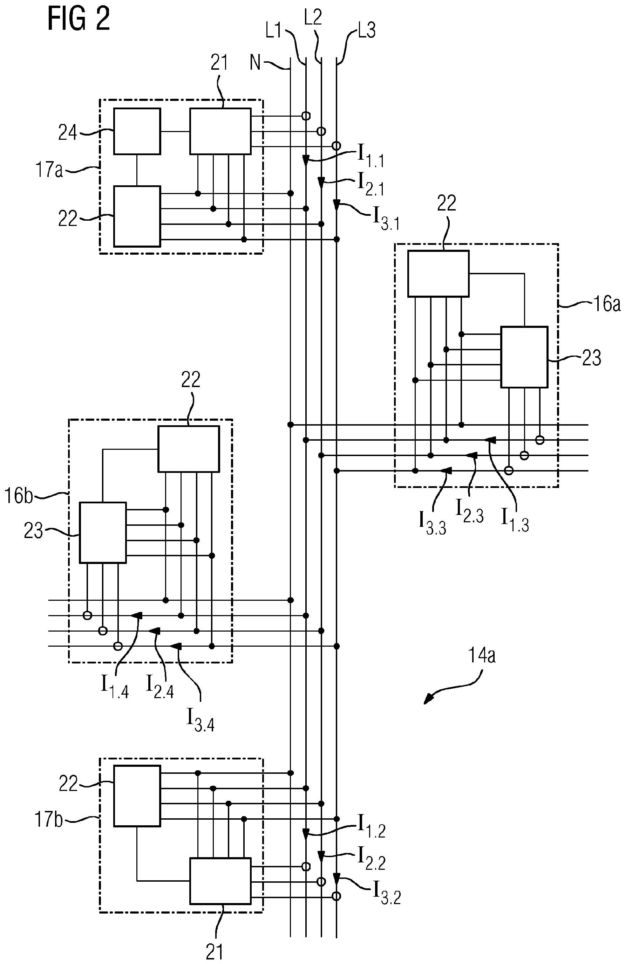

Der Verteilnetzbereich mit dem Netzstrang 14a ist in der Figur 2 detaillierter dargestellt. Die Strommesseinrichtungen 17a und 17b umfassen eine Vorrichtung 21 zur Erfassung und Bearbeitung von Strömen und Spannungen und eine Kommunikationsvorrichtung 22, die mit Phasenleitern L1, L2 und L3 und/oder dem Nullleiter N verbunden ist und über diese kommuniziert. Die Energiezähler 16a und 16b beinhalten eine Vorrichtung 23, die neben der eigentlichen Energiezählung auch eine Erfassung und Bearbeitung von Strömen und Spannungen einzelner Netzleitungen durchführt. Außerdem umfassen die Energiezähler 16a, 16b ebenfalls Kommunikationsvorrichtungen 22. Sowohl die Energiezähler 16a und 16b als auch die Strommesseinrichtung 17b kommunizieren mit der Strommesseinrichtung 17a, insbesondere mit einer Zentraleinrichtung 24, die in der Strommesseinrichtung 17a enthalten ist und unter anderem den Netzstrang 14a überwacht.

Die Überwachung der Ströme im Verteilnetzstrang 14a erfolgt in aneinander reihenden Messzyklen, die durch die Zentraleinrichtung 24 initiiert werden. Zu Beginn eines Messzyklus sendet die Zentraleinrichtung 24 an alle Vorrichtungen 21, 23 entweder direkt, wie in der Strommesseinrichtung 17a, oder unter Verwendung eines PLC-Verfahrens (PLC = Power Line Communication) über die Kommunikationsvorrichtungen 22 ein Starttelegram, das eine Messung und deren Dauer initiiert. Am Ende der Messung werden in den Vorrichtungen 21, 23 der Energiezähler 16a und 16b und in der Strommesseinrichtung 17a Mittelwerte der Beträge der Wirkströme in den Phasenleitern der überwachten Verteilnetzabzweige (I_{1.1}, I_{2.1}, I_{3.1}, I_{1.2}, I_{2.2}, I_{3.2}, I_{1.3}, I_{2.3}, I_{3.3}, I_{1.4}, I_{2.4} bzw. I_{3.4}) gebildet. Diese Werte werden nach der Messung über dieselben Kommunikationsverbindungen an die Zentraleinrichtung 24 in der Strommesseinrichtung 17a übermittelt.

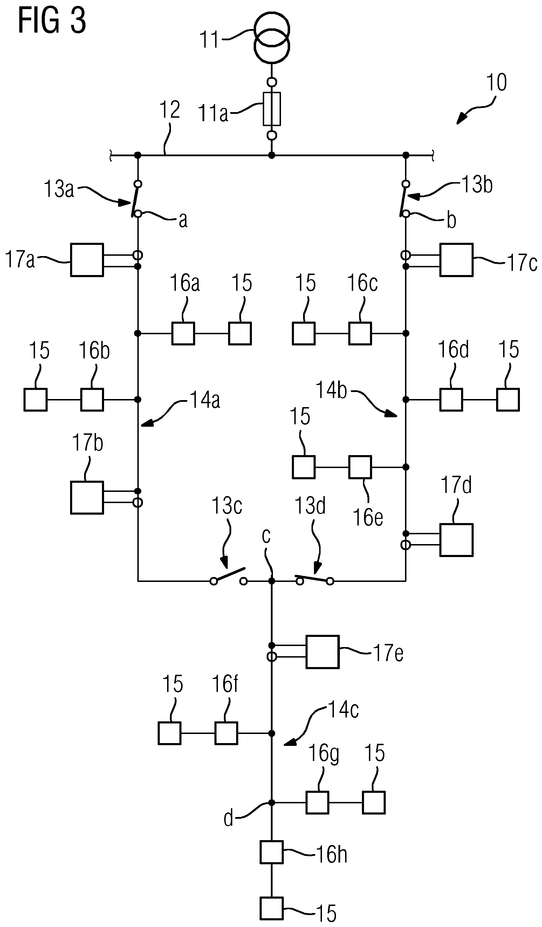

Aus den übermittelten Wirkstrommittelwerten kann in der Zentraleinrichtung 24 beispielsweise abgeschätzt werden, ob die in die Phasenleitung L2 einfließenden Ströme I_{2.1} und I_{2.3} in der Summe einen gewissen Planwert (Schwellenwert) I_{2.max} überschreiten. Wenn die Stromsumme einen überhöhten Wert ergibt und auch der aus dem Strang ausfließende Strom I_{2.2} und I_{2.4} nicht vernachlässigbar gering ist, könnte die Zentraleinrichtung 24 eine Alarmnachricht an die den Netzbetrieb führende Stelle versenden, um damit zu signalisieren, dass der Netzabschnitt mit dem Strang 14c nicht mehr über den Strang 14a, sondern besser über den Strang 14b versorgt werden soll. Dies kann durch ein Öffnen der Schalteinrichtung 13c und ein Schließen der Schalteinrichtung 13d erfolgen, wie dies in der Figur 3 dargestellt ist.

Außerdem kann in der Zentraleinrichtung 24 eine Erkennung durchgeführt werden, ob der von den beteiligten Strommesseinrichtungen 17a, 17b und Energiezählern 16a, 16b abgegrenzte Bereich last- und quellenfrei ist, also ob an keiner weiteren Stelle Wirkstrom in den Bereich hinein- oder aus diesem herausfließt. Wenn nämlich die jeweils aus allen Wirkstromwerten eines Phasenleiters gebildete Wirkstromsumme betragsmäßig einen Schwellenwert nicht überschreitet - also nahe am Wert Null liegt - wird ein von den Strommesseinrichtungen 17a und 17b und den Energiezählern 16a und 16b vollständig abgegrenzter last- und quellenfreier Bereich erkannt und es wird von der Zentraleinrichtung 24 eine Topologieinformation erzeugt und z.B. an eine Netzleitstelle übermittelt.

Auf die gleiche Art und Weise erfolgt die Überwachung der Netzstränge 14b und 14c durch die Strommesseinrichtungen 17c und 17d sowie die Energiezähler 16c bis 16e bzw. durch die Strommesseinrichtung 17e und die Energiezähler 16f bis 16h. Aus den übermittelten Wirkstrommittelwerten kann beispielsweise in der Zentraleinrichtung 24 festgestellt werden, wie der momentane Schaltzustand der Schalteinrichtungen 13c und 13d und die aktuelle Netzkonfiguration/-topologie ist. So kann festgestellt werden, ob der Netzstrang 14c mit dem Netzstrang 14a oder mit dem Netzstrang 14b oder mit beiden verbunden ist und wie sich der Stromfluss zwischen den genannten Netzbereichen aufteilt. Es können also beispielsweise Topologieinformationen über das elektrische Niederspannungsverteilnetz gewonnen werden, indem eine Gruppe von mindestens zwei an unterschiedlichen Stellen des Niederspannungsverteilnetzes angeordneten Strommesseinrichtungen ausgewählt wird, mit den Strommesseinrichtungen jeweils der Strom unter Bildung eines Strommesswerts gemessen wird, die Strommesswerte unter Berücksichtigung der Stromflussrichtung unter Bildung einer Stromsumme addiert werden und eine Topologieinformation gebildet wird, die angibt, dass die Strommesseinrichtungen einen last- und quellenfreien Abschnitt des Niederspannungsverteilnetzes elektrisch abgrenzen, wenn die Stromsumme einen vorgegebenen Schwellenwert unterschreitet.

Über solche Topologieinformationen als last- und quellenfrei erkannte Bereiche können dann beispielsweise in einer Netzleitstelle zur Gewinnung eines Topologieabbildes herangezogen werden. Ebenso können Änderungen der Topologie erkannt werden, wenn zu einem bisher als last- und quellenfrei erkannten Bereich plötzlich keine Topologieinformation mehr gebildet werden kann.

Zusammenfassend kann das Niederspannungsverteilnetz bzw. das Verfahren zu dessen Betrieb eines oder mehrere der folgenden Merkmale aufweisen:
Zur Erfassung der für die Verteilung elektrischer Energie relevanten Parameter, insbesondere Wirk- und/oder Blindströme unter Berücksichtigung der Netzspannungen bzw. deren Qualität, kann für zumindest ein Teil des Verteilnetzes ein System installiert werden, das aus mindestens einer Zentraleinrichtung und aus mindestens einer Strommesseinrichtung besteht.

Die Strommesseinrichtungen können in mindestens einem Teil eines Wechselstromverteilnetzes an den Netzstellen installiert werden, die für die Überwachung der topologischen Eigenschaften des Wechselstromverteilnetzes und/oder des Wechselstromverteilnetzteils besonders wichtig sind, wie beispielsweise Netzleitungsabzweige, -gabelungen, -knoten, -trennstellen und ähnliche Komponenten, und mit mindestens einer gemeinsamen Netzleitung (Phasenleiter oder Nullleiter) verbunden sind.

Die Verteilnetztopologieeingrenzung und -überwachung kann beispielsweise erfolgen durch:
- die Erfassung der Schaltzustände der Trennstellen in mindestens einer Netzleitung;
- die Strommesseinrichtungen;
- die Bildung und Überwachung von Wirkstrombilanzen in Verteilnetzteilbereichen/-abschnitten durch die mindestens eine Zentraleinrichtung aufgrund der Daten, welche der Zentraleinrichtung von den Strommesseinrichtungen übermittelt wurden; ein zu überwachender Verteilnetzteilbereich/-abschnitt kann mit den Strommesseinrichtungen so abgegrenzt werden, dass sich innerhalb des Bereichs keine Lasten oder Energiequellen befinden; das System aus den Strommesseinrichtungen kann beispielsweise zum Ziel haben, die zusammengehörigen Wirk- und/oder Blindströme, die in mindestens eine der Leitungen des Verteilnetzes ein- und ausfließen, sowie andere für die Verteilung der elektrischen Energie relevanten Parameter, insbesondere Netzspannungen bzw. deren Merkmale synchron zu erfassen und die erfassten Daten über eine Kommunikationseinrichtung, die einen Teil der Strommesseinrichtungen darstellen kann, zu der mindestens einen Zentraleinrichtung zu übermitteln;
- eine anschließende Analyse (zum Beispiel in der mindestens einen Zentraleinrichtung) der erfassten und übermittelten Schaltzustände der Trennstellen und/oder der Wirkstrombilanzen der Verteilnetzteilbereiche/-abschnitte, die Rückschlüsse über topologische Veränderungen im Verteilnetz (Zusammenschaltung/Trennung der Verteilnetzbereiche, Zu-/Abschaltung nicht erfasster Verbraucher/Stromerzeuger in abgegrenzten Verteilnetzbereichen und Ähnliches ermöglichen kann.

Die Überwachung der Stromverteilung insbesondere der Wirk- und/oder Blindströme unter Berücksichtigung der Netzspannungen bzw. deren Qualität im Verteilnetz kann in der mindestens einen Zentraleinrichtung auf Basis der Daten erfolgen, welche der Zentraleinrichtung von den Strommesseinrichtungen übermittelt wurden. Dafür werden abhängig von der erfolgten Eingrenzung der Verteilnetztopologie (siehe vorige Punkte) die in die überwachten Verteilnetzabschnitte/-bereiche ein-, aus- und/oder durchfließenden Wirk- und/oder Blindströme hinsichtlich deren Höhe bewertet und bei Überschreitung voreingestellter Schwellenwerte einem weiteren System (z. B. einem Verteilnetzmanagementsystem) übermittelt. Ergänzend oder alternativ dazu können Summen aus den Wirk- und/oder Blindströmen, die in den überwachten Verteilnetzabschnitt/-bereich einfließen, respektive aus diesem ausfließen, jeweils gebildet werden, um in weiterer Folge eine Wirk- bzw. Blindstromdurchflussbilanz für den Verteilnetzabschnitt/-bereich zu erstellen. Diese Stromdurchflussbilanzen können auch hinsichtlich deren Höhe bewertet werden und bei Überschreitung voreingestellter Schwellenwerte einem weiteren System (z. B. einem Verteilnetzmanagementsystem) übermittelt werden. Außerdem lässt der Vergleich der Strombilanz der wichtigen Versorgungsstränge des Verteilnetzbereiches/-abschnitts mit der Strombilanz der in dem Bereich angeschlossenen Energieverbraucher und -erzeuger darauf schließen, wie viel von der Stromtransportkapazität für die Eigenstromerzeugung und -verbrauch innerhalb des Verteilnetzbereiches genutzt wird respektive wie viel der Stromtransportkapazität für die Stromdurchleitung zu den anderen Verteilnetzbereichen übrig bleibt.

Die Überwachung der Spannungsqualität bzw. der Merkmale der Netzspannung, insbesondere der Spannungsschwankungen, -einbrüche, -unterbrechungen, -flicker, -oberschwingungen u. ä., erfolgt gepaart mit der Überwachung der Verteilnetztopologie und/oder der Stromverteilung insbesondere der Wirk- und/oder Blindströme in der mindestens einen Zentraleinrichtung und/oder dem weiteren System (z. B. einem Verteilnetzmanagementsystem). Dies hat zum Ziel, die Leistungstransportfähigkeit des Verteilnetzes bzw. dessen Schwachstellen zu überwachen, indem die Spannungsqualitätsmerkmale insbesondere bei erhöhter Strombelastung der abgegrenzten Verteilnetzbereiche/-abschnitte oder einzelner Netzleitungen analysiert und bewertet werden, um gegebenenfalls Maßnahmen zum Schutz des Verteilnetzes zu ergreifen (wie z. B. eine zeitweilige Lastenreduktion im Netz oder einen nachhaltigen Ausbau der zu schwach dimensionierten Netzleitungen).

Vor oder während der Installation der Strommesseinrichtungen oder auch während des späteren Betriebs der Strommesseinrichtungen werden vorzugsweise folgende netztopologischen Parameter festgelegt:
- die Zuordnung der Netzleiteranschlüsse zu den Anschlüssen der Strommesseinrichtung;
- die Zuordnung der Netzleiteranschlüsse gemäß einer gemeinsamen Kennzeichnung der Phasenleitungen im Verteilnetz (einer einheitlichen Phasenkennung), wenn vor Ort möglich;
- der netztopologische Bezug einer positiven/negativen Stromflussrichtung; es kann beispielsweise festgelegt werden, dass alle Wirkströme, die in den abgegrenzten Verteilnetzbereich einfließen, als negativ bzw. alle solchen, die hinausfließen, als positiv zu werten sind.

Alternativ kann der netztopologische Bezug einer positiven/negativen Stromflussrichtung erst bei der Bildung einer Stromsummenbilanz festgelegt bzw. berücksichtigt werden.

Eine synchrone Erfassung der zusammengehörigen Ströme sowie anderer für die Verteilung der elektrischen Energie relevanten Parameter kann im System je nach Bedarf fortlaufend, über eine begrenzte Zeitdauer einmal oder mehrmals sporadisch oder stichprobenartig durchgeführt werden.

Die Steuerung der synchronen Erfassung im System erfolgt vorzugsweise entweder zeitgesteuert (z. B. mit Beginn zu jeder vollen Stunde) oder per Befehl von einem führenden Stromwächter oder einer der weiteren Vorrichtungen. Im Fall einer zeitgesteuerten Erfassung werden die internen Zeitreferenzen/Uhren in den Strommesseinrichtungen vorher vorzugsweise aus der Ferne oder per lokaler Einstellung synchronisiert.

Die erfassten Werte/Parameter können von den Strommesseinrichtungen zu mindestens einer der Strommesseinrichtungen oder zu mindestens einer separaten Zentraleinrichtung über die Kommunikationsverbindungen übertragen werden.

Um die Menge der zu übertragenen Daten zu verringern, können statt den Einzelabtastungen der Werte/Parameter deren integrale Werte der Parameter (z. B. stromflussrichtungsbezogene Wirkstrommittelwerte innerhalb einer Erfassungsperiode, o. Ähnliches) in den Strommesseinrichtungen gebildet und übertragen werden.

Eine Zuordnung der Netzleiteranschlüsse gemäß einer gemeinsamen Kennzeichnung der Phasenleitungen im Verteilnetz kann zusätzlich oder alternativ auch automatisch per Ferne in den Strommesseinrichtungen selbst oder in der Zentraleinrichtung oder in den Strommesseinrichtungen, in denen die Überwachung durchgeführt wird, ermittelt werden.

Wenn die phasenleiterbezogene Zuordnung der Anschlüsse der Strommesseinrichtungen nicht möglich oder erschwert ist, erfolgt die Überwachung des Verteilnetzes vorzugsweise gemeinsam für alle oder mehrere Phasenleitungen.

Durch eine Installation mehrerer Strommesseinrichtungen in einem Verteilnetz können auch mehrere eventuell sich überlappende, aneinander grenzende oder unabhängige Bilanzgruppen gebildet werden. Dabei können einige Strommesseinrichtungen mehreren Strombilanzgruppen und/oder mehreren Netztrennstellen angehören. In dem Fall kann beispielsweise ein besonderes Augenmerk auf die Stromflussrichtung in einem solchen Stromwächter gelegt werden, die für benachbarte Bilanzgruppen unterschiedlich zu werten sein kann.

Die oben beschriebene mindestens eine Zentraleinrichtung kann auch eine Teilfunktionalität einer Strommesseinrichtung sein. Eine Strommesseinrichtung kann auch die Funktionalität mehrerer der vorherbeschriebenen Strommesseinrichtungen umfassen.

Die oben beschriebene Funktionalität einer Strommesseinrichtung und/oder einer weiteren Vorrichtung kann auch als eine Teilfunktionalität eines Energiezählers, eines Spannungsqualitätsmessgerätes, eines Datenkonzentrators oder eines Automatisierungsgerätes realisiert werden.

Als Kommunikationsmedium für die Kommunikationsvorrichtungen bzw. Kommunikationsinfrastruktur kann das Verteilnetz selbst oder ein separates Kommunikationsnetz dienen.

Zusammengefasst ist eine automatische Überwachung der Topologie eines elektrischen Energieverteilnetzes, insbesondere dessen Schaltzustände sowie Veränderungen in der Topologie einzelner Verteilnetzbereiche/-abschnitte, durch den Einsatz der Strommesseinrichtungen möglich. Diese können in einem Verteilnetz so platziert werden, dass eine exakte Kenntnis der Netztopologie nicht notwendig ist und nur eine relativ grobe Struktur der Netztopologie, wie beispielsweise Netzleitungsstränge zwischen den wichtigen Netzknoten/-trennstellen sowie deren Schaltzustand, zumindest im überwachten Netzbereich bekannt ist. Solche Netzbereiche/-abschnitte können als "Ganzes" hinsichtlich der ein-, aus- und durchfließenden Ströme und unter der Berücksichtigung der Spannungsqualität überwacht werden. Vorteilhaft ist hierbei insbesondere, dass man entlang eines Stranges keine Strommesseinrichtungen benötigt, sondern nur an dessen Enden/Trennstellen. Die restlichen Ströme von/zu den einzelnen Energieverbrauchern/-lieferanten können beispielsweise durch sogenannte "Smart-Grid-Energiezähler" mit entsprechender Funktionalität erfasst und der Zentraleinrichtung übermittelt werden.

Eine synchrone Erfassung der Ströme und die nachfolgende Analyse der Ströme und deren Bilanzen erlauben eine Überwachung der Transportkapazität einzelner Verteilnetzbereiche, um eine ausreichende Versorgungsspannungsqualität und einen sicheren Verteilnetzbetrieb, insbesondere bei vielen verteilten Energieerzeugern, zu sichern.

Durch den Einsatz der Strommesseinrichtungen ist es außerdem möglich, die überwachten Verteilnetzbereiche in deren Größe nahezu beliebig zu skalieren oder nur bestimmte örtlich begrenzte Teile des Verteilnetzes zu überwachen.

Außerdem kann das beschriebene Verfahren unter Verwendung von in einem Verteilnetz bereits ohnehin installierter Infrastruktur, wie E-Zählern, Spannungsqualitätsmessgeräten oder Automatisierungsgeräten, realisiert werden.

## Patentansprüche

1. Verfahren zum Ermitteln einer Topologieinformation über ein elektrisches Niederspannungsverteilnetz (10), wobei bei dem Verfahren
(a) eine Gruppe von mindestens zwei an unterschiedlichen Stellen des Niederspannungsverteilnetzes (10) angeordneten Strommesseinrichtungen (17a-17e, 16a-16h) ausgewählt wird,
(b) mit den Strommesseinrichtungen (17a-17e, 16a-16h) jeweils der Strom unter Bildung eines Strommesswerts gemessen wird, wobei als Strommesswerte zeitlich gemittelte Strommesswerte der Grundschwingung des durch die jeweilige Strommesseinrichtungen (17a-17e, 16a-16h) fließenden Stromes gebildet werden, wobei den Strommesseinrichtungen (17a-17e, 16a-16h) ein Startzeitpunkt und eine Zeitdauer einer Messung des Stroms mittels eines Startsignals vorgegeben wird und wobei von einem zumindest ersten Strommesswert der für die vorgegebene Zeitdauer gemittelte Wirkstrom der Grundschwingung des durch die jeweilige Strommesseinrichtung fließenden Stromes angegeben wird und von einem zumindest zweiten Strommesswert der für dieselbe vorgegebene Zeitdauer gemittelte Blindstrom der Grundschwingung des durch die jeweilige Strommesseinrichtung fließenden Stromes angegeben wird;
(c) die Strommesswerte unter Berücksichtigung der Stromflussrichtung unter Bildung einer Stromsumme addiert werden und
(d) eine Topologieinformation gebildet wird, die angibt, dass die Strommesseinrichtungen (17a-17e, 16a-16h) einen last- und quellenfreien Abschnitt des Niederspannungsverteilnetzes (10) elektrisch abgrenzen, wenn die Stromsumme einen vorgegebenen Schwellenwert betragsmäßig unterschreitet.

2. Verfahren nach Anspruch 1,
**dadurch gekennzeichnet, dass**
(e) im Falle, dass in Schritt (d) keine Topologieinformation gebildet worden ist, eine neue Gruppe von mindestens zwei an unterschiedlichen Stellen des Niederspannungsverteilnetzes (10) angeordneten Strommesseinrichtungen (17a-17e, 16a-16h) ausgewählt wird,
(f) mit den Strommesseinrichtungen (17a-17e, 16a-16h) der neuen Gruppe der Strom jeweils unter Bildung eines neuen Strommesswerts gemessen wird,
(g) die neuen Strommesswerte unter Berücksichtigung der Stromflussrichtung unter Bildung einer neuen Stromsumme addiert werden,
(h) eine Topologieinformation gebildet wird, die angibt, dass die Strommesseinrichtungen (17a-17e, 16a-16h) einen last- und quellenfreien Abschnitt des Niederspannungsverteilnetzes (10) elektrisch abgrenzen, wenn die neue Stromsumme den vorgegebenen Schwellenwert betragsmäßig unterschreitet, und
(i) die Schritte (e) bis (h) wiederholt werden, bis eine Topologieinformation gebildet worden ist.

3. Verfahren nach Anspruch 2,
**dadurch gekennzeichnet, dass**
- vor der Auswahl der neuen Gruppe eine weitere Strommesseinrichtung an das elektrische Niederspannungsverteilnetz (10) angeschlossen wird, wobei die weitere Strommesseinrichtung den Strom durch eine zugeordnete Schalteinrichtung des Niederspannungsverteilnetzes misst, und
- diese weitere Strommesseinrichtung zu der neuen Gruppe von Strommesseinrichtungen hinzugefügt wird.

4. Verfahren nach einem der voranstehenden Ansprüche,
**dadurch gekennzeichnet, dass** die zeitlich gemittelten Strommesswerte zeitlich gemittelte Effektivwerte, zeitlich gemittelte Amplitudenwerte oder zeitlich gemittelte Scheitelwerte der Grundschwingung des Stromes sind.

5. Niederspannungsverteilnetz mit
- mindestens einer Schalteinrichtung (13a-13d),
- mindestens eine Gruppe von mindestens zwei Strommesseinrichtungen (17a-17e, 16a-16h), die jeweils einer Stelle des Niederspannungsverteilnetzes (10) zugeordnet sind und
- einer mit den Strommesseinrichtungen (17a-17e, 16a-16h) in Verbindung stehenden Zentraleinrichtung (24),
- wobei die Strommesseinrichtungen (17a-17e, 16a-16h) geeignet sind, den durch die mindestens eine Schalteinrichtung (13a-13d) fließenden Strom unter Bildung zumindest eines Strommesswerts zu messen, und den zumindest einen Strommesswert zu der Zentraleinrichtung (24) zu übertragen;
- wobei die Strommesseinrichtungen (17a-17e, 16a-16h) derart ausgestaltet sind, dass sie als Strommesswert einen zeitlich gemittelten Strommesswert der Grundschwingung des Stromes bilden, wobei der zeitlich gemittelte Strommesswert den für die vorgegebene Zeitdauer zeitlich gemittelten Wirkstrom der Grundschwingung des Stromes oder den für die vorgegebene Zeitdauer zeitlich gemittelten Blindstrom der Grundschwingung des Stromes angibt;
- wobei die Strommesswerte unter Berücksichtigung einer Stromflussrichtung unter Bildung einer Stromsumme addierbar sind,
- wobei eine Topologieinformation bildbar ist, die angibt, dass die Strommesseinrichtungen (17a-17e; 16a-16h) einen last- und quellenfreien Abschnitt des Niederspannungs-verteilnetzes (10) elektrisch abgrenzen, wenn die Stromsumme einen vorgegebenen Schwellwert betragsmäßig unterschreitet,
- und wobei den Strommesseinrichtung (17a-17e, 16a-16h) ein Startzeitpunkt und eine Zeitdauer einer Messung des Stroms mittels eines Startsignals vorgebbar ist.

6. Niederspannungsverteilnetz nach Anspruch 5, **dadurch gekennzeichnet, dass**
die Zentraleinrichtung (24) einen Bestandteil der Strommesseinrichtung (17a-17e, 16a-16h) bildet.

7. Niederspannungsverteilnetz nach einem der voranstehenden Ansprüche 5-6, **dadurch gekennzeichnet, dass**
der zeitlich gemittelte Strommesswert ein zeitlich gemittelter Effektivwert, ein zeitlich gemittelter Amplitudenwert oder ein zeitlich gemittelter Scheitelwert der Grundschwingung des Stromes ist.

8. Niederspannungsverteilnetz nach einem der voranstehenden Ansprüche 5-7 **dadurch gekennzeichnet, dass**
- die mindestens eine Strommesseinrichtung (17a-17e, 16a-16h) derart ausgestaltet ist, dass sie zumindest zwei zeitlich gemittelte Strommesswerte ermittelt und an die Zentraleinrichtung (24) überträgt,
- von denen ein erster Strommesswert den für die vorgegebene Zeitdauer gemittelten Wirkstrom der Grundschwingung des Stromes angibt und
- von denen ein zweiter Strommesswert den für dieselbe vorgegebene Zeitdauer gemittelten Blindstrom der Grundschwingung des Stromes angibt.

9. Niederspannungsverteilnetz nach einem der voranstehenden Ansprüche 5-8, **dadurch gekennzeichnet, dass**
die Strommesseinrichtungen (17a-17e, 16a-16h) der Gruppe einen last- und quellenfreien Abschnitt des Niederspannungsverteilnetzes (10) abgrenzen.

10. Niederspannungsverteilnetz nach Anspruch 5 bis 9, **dadurch gekennzeichnet, dass**
die Strommesseinrichtungen (17a-17e, 16a-16h) der Gruppe ihre Strommesswerte synchron bilden.

11. Niederspannungsverteilnetz nach Anspruch 5 bis 10, **dadurch gekennzeichnet, dass**
die Strommesseinrichtungen (17a-17e, 16a-16h) der Gruppe ihre Strommesswerte jeweils für dieselbe vorgegebene Zeitdauer zeitlich mitteln.

12. Niederspannungsverteilnetz nach Anspruch 11, **dadurch gekennzeichnet, dass**
die vorgegebene Zeitdauer größer ist als das Zehnfache des zeitlichen Synchronisierungsfehlers der Strommesseinrichtungen (17a-17e, 16a-16h) der Gruppe.

13. Niederspannungsverteilnetz nach einem der voranstehenden Ansprüche 5-12, **dadurch gekennzeichnet, dass**
die Zentraleinrichtung (24) geeignet ist, die Verfahrensschritte zur Bildung einer Topologieinformation nach einem der Verfahrensansprüche 1-2 auszuführen.

## Claims

1. Method for determining a topology information item on a low-voltage electrical distribution system (10), wherein in the method
(a) a group of at least two current-measuring devices (17a-17e, 16a-16h) arranged at different points in the low-voltage distribution system (10) is selected,
(b) in each case the current is measured by the current-measuring devices (17a-17e, 16a-16h) so as to form a current measurement value, wherein time-averaged current measurement values of the fundamental component of the current flowing through the respective current-measuring devices (17a-17e, 16a-16h) are formed as current measurement values, wherein a start time and a period for a measurement of the current are predetermined for the current-measuring devices (17a-17e, 16a-16h) by means of a start signal and wherein the active current, averaged for the predetermined period, of the fundamental component of the current flowing through the respective current-measuring device is specified by an at least first current measurement value and the reactive current, averaged for the same predetermined period, of the fundamental component of the current flowing through the respective current-measuring device is specified by an at least second current measurement value,
(c) the current measurement values are added so as to form a current sum taking into consideration the current flow direction
and
(d) a topology information item is formed, which specifies that the current-measuring devices (17a-17e, 16a-16h) electrically isolate a load-free and source-free section of the low-voltage distribution system (10) when the current sum, in terms of absolute value, falls below a predetermined threshold value.

2. Method according to claim 1,
**characterised in that**
(e) in the event that in step (d) no topology information item has been formed, a new group of at least two current-measuring devices (17a-17e, 16a-16h) arranged at different points in the low-voltage distribution system (10) is selected,
(f) in each case the current is measured by the current-measuring devices (17a-17e, 16a-16h) of the new group so as to form a new current measurement value,
(g) the new current measurement values are added so as to form a new current sum taking into consideration the current flow direction,
(h) a topology information item is formed, which indicates that the current-measuring devices (17a-17e, 16a-16h) electrically isolate a load-free and source-free section of the low-voltage distribution system (10), when the new current sum, in terms of absolute value, falls below the predetermined threshold value, and
(i) steps (e) to (h) are repeated until a topology information item has been formed.

3. Method according to claim 2,
**characterised in that**
- before the selection of the new group, a further current-measuring device is connected to the low-voltage electrical distribution system (10), wherein the further current-measuring device measures the current by an assigned switching device of the low-voltage distribution system, and
- this further current-measuring device is added to the new group of current-measuring devices.

4. Method according to one of the preceding claims,
**characterised in that**
the time-averaged current measurement values are time-averaged root-mean-square values, time-averaged amplitude values or time-averaged peak values of the fundamental component of the current.

5. Low-voltage distribution system having
- at least one switching device (13a-13d),
- at least one group of at least two current-measuring devices (17a-17e, 16a-16h), which are in each case assigned to a point in the low-voltage distribution system (10) and
- a central device (24) connected to the current-measuring devices (17a-17e, 16a-16h),
- wherein the current-measuring devices (17a-17e, 16a-16h) are suitable for measuring the current flowing through the at least one switching device (13a-13d) so as to form at least one current measurement value, and for transmitting the at least one current measurement value to the central device (24),
- wherein the current-measuring devices (17a-17e, 16a-16h) are embodied such that they form a time-averaged current measurement value of the fundamental component of the current as a current measurement value, wherein the time-averaged current measurement value indicates the active current, time-averaged for the predefined period, of the fundamental component of the current or the reactive current, time-averaged for the predefined period, of the fundamental component of the current,
- wherein the current measurement values can be added so as to form a current sum taking into consideration a current flow direction,
- wherein a topology information item can be formed, which specifies that the current-measuring devices (17a-17e, 16a-16h) electrically isolate a load-free and source-free section of the low-voltage distribution system (10) when the current sum, in terms of absolute value, falls below a predetermined threshold value,
- and wherein a start time and a period for a measurement of the current can be predetermined for the current-measuring devices (17a-17e, 16a-16h) by means of a start signal.

6. Low-voltage distribution system according to claim 5,
**characterised in that**
the central device (24) forms a component of the current-measuring device (17a-17e, 16a-16h).

7. Low-voltage distribution system according to one of the preceding claims 5-6,
**characterised in that**
the time-averaged current measurement value is a time-averaged root-mean-square value, a time-averaged amplitude value or a time-averaged peak value of the fundamental component of the current.

8. Low-voltage distribution system according to one of the preceding claims 5-7,
**characterised in that**
- the at least one current-measuring device (17a-17e, 16a-16h) is embodied such that it determines at least two time-averaged current measurement values and transmits them to the central device (24),
- of which a first current measurement value indicates the active current, averaged for the predetermined period, of the fundamental component of the current and
- of which a second current measurement value indicates the reactive current, averaged for the same predetermined period, of the fundamental component of the current.

9. Low-voltage distribution system according to one of the preceding claims 5-8,
**characterised in that**
- the current-measuring devices (17a-17e, 16a-16h) in the group isolate a load-free and source-free section of the low-voltage distribution system (10).

10. Low-voltage distribution system according to claim 5 to 9,
**characterised in that**
the current-measuring devices (17a-17e, 16a-16h) in the group form their current measurement values synchronously.

11. Low-voltage distribution system according to claim 5 to 10,
**characterised in that**
the current-measuring devices (17a-17e, 16a-16h) in the group in each case determine the time average of their current measurement values for the same predetermined period.

12. Low-voltage distribution system according to claim 11,
**characterised in that**
the predetermined period is greater than ten times the temporal synchronisation error of the current-measuring devices (17a-17e, 16a-16h) in the group.

13. Low-voltage distribution system according to one of the preceding claims 5-12,
**characterised in that**
the central device (24) is suitable for performing the method steps in order to form a topology information item according to one of the method claims 1-2.

## Revendications

1. Procédé de détermination d'informations de topologie sur un réseau de distribution basse tension électrique (10), ledit procédé comprenant les étapes suivantes :
(a) un groupe d'au moins deux dispositifs de mesure de courant (17a-17e, 16a-16h) disposés en différents endroits du réseau de distribution basse tension (10) est sélectionné,
(b) le courant est mesuré respectivement au moyen des dispositifs de mesure de courant (17a-17e, 16a-16h) de manière à former une valeur de courant mesurée, dans lequel des valeurs de courant mesurées moyennées au cours du temps de la composante fondamentale du courant circulant à travers les dispositifs de mesure de courant respectifs (17a-17e, 16a-16h) sont constituées en tant que valeurs de courant mesurées, un point de départ et une durée d'une mesure du courant sont prédéfinis au moyen d'un signal de départ pour les dispositifs de mesure de courant (17a-17e, 16a-16h) et dans lequel le courant actif de la composante fondamentale du courant circulant à travers le dispositif de mesure de courant respectif, moyenné pour la durée prédéfinie, est indiqué par au moins une première valeur de courant mesurée et le courant réactif de la composante fondamentale du courant circulant à travers le dispositif de mesure de courant respectif, moyenné pour la même durée prédéfinie, est indiqué par au moins une seconde valeur de courant mesurée,
(c) les valeurs de courant mesurées sont additionnées, en tenant compte du sens de circulation du courant, de manière à former une somme de courant et
(d) des informations de topologie sont constituées, lesquelles indiquent que les dispositifs de mesure de courant (17a-17e, 16a-16h) délimitent électriquement un segment exempt de charge et de source du réseau de distribution basse tension (10) lorsque la somme de courant devient quantitativement inférieure à une valeur seuil prédéterminée.

2. Procédé selon la revendication 1, **caractérisé en ce que** :
(e) dans le cas où, à l'étape (d), aucune information de topologie n'a été constituée, un nouveau groupe d'au moins deux dispositifs de mesure de courant (17a-17e, 16a-16h) disposés en différents endroits du réseau de distribution basse tension (10) est sélectionné,
(f) le courant est mesuré respectivement au moyen des dispositifs de mesure de courant (17a-17e, 16a-16h) du nouveau groupe de manière à former une nouvelle valeur de courant mesurée,
(g) les nouvelles valeurs de courant mesurées sont additionnées, en tenant compte du sens de circulation du courant, de manière à former une nouvelle somme de courant,
(h) des informations de topologie sont constituées, lesquelles indiquent que les dispositifs de mesure de courant (17a-17e, 16a-16h) délimitent électriquement un segment exempt de charge et de source du réseau de distribution basse tension lorsque la nouvelle somme de courant devient quantitativement inférieure à la valeur seuil prédéterminée, et
(i) les étapes (e) à (h) sont répétées jusqu'à ce que des informations de topologie soient constituées.

3. Procédé selon la revendication 2, **caractérisé en ce que** :
- avant la sélection du nouveau groupe, un dispositif de mesure de courant supplémentaire est connecté au réseau de distribution basse tension électrique (10), dans lequel le dispositif de mesure de courant supplémentaire mesure le courant à travers un dispositif de commutation associé du réseau de distribution basse tension, et
- ce dispositif de mesure de courant supplémentaire est ajouté au nouveau groupe de dispositifs de mesure de courant.

4. Procédé selon l'une des revendications précédentes, **caractérisé en ce que** les valeurs de courant mesurées moyennées au cours du temps sont des valeurs efficaces moyennées au cours du temps, des valeurs d'amplitude moyennées au cours du temps ou des valeurs de crête moyennées au cours du temps de la composante fondamentale du courant.

5. Réseau de distribution basse tension comprenant
- au moins un dispositif de commutation (13a-13d),
- au moins un groupe d'au moins deux dispositifs de mesure de courant (17a-17e, 16a-16h) qui sont affectés respectivement à un endroit du réseau de distribution basse tension (10) et
- un dispositif central (24) communiquant avec les dispositifs de mesure de courant (17a-17e, 16a-16h),
- dans lequel les dispositifs de mesure de courant (17a-17e, 16a-16h) sont appropriés pour mesurer le courant circulant à travers le au moins un dispositif de commutation (13a-13d) de manière à former au moins une valeur de courant mesurée, et pour transmettre la au moins une valeur de courant mesurée au dispositif central (24),
- dans lequel les dispositifs de mesure de courant (17a-17e, 16a-16h) sont configurés de manière à constituer une valeur de courant mesurée moyennée au cours du temps de la composante fondamentale du courant en tant que valeur de courant mesurée, et la valeur de courant mesurée moyennée au cours du temps indique le courant actif moyenné au cours du temps pour la durée prédéfinie de la composante fondamentale du courant ou le courant réactif moyenné au cours du temps pour la durée prédéfinie de la composante fondamentale du courant,
- dans lequel les valeurs de courant mesurées peuvent être additionnées, en tenant compte du sens de circulation du courant, de manière à former une somme de courant,
- dans lequel des informations de topologie peuvent être constituées, lesquelles indiquent que les dispositifs de mesure de courant (17a-17e, 16a-16h) délimitent électriquement un segment exempt de charge et de source du réseau de distribution basse tension (10) lorsque la somme de courant devient quantitativement inférieure à une valeur seuil prédéterminée, et
- dans lequel un point de départ et une durée d'une mesure du courant sont prédéfinis au moyen d'un signal de départ pour les dispositifs de mesure de courant (17a-17e, 16a-16h) .

6. Réseau de distribution basse tension selon la revendication 5, **caractérisé en ce que** le dispositif central (24) forme un élément du dispositif de mesure de courant (17a-17e, 16a-16h).

7. Réseau de distribution basse tension selon l'une des revendications 5 et 6, **caractérisé en ce que** la valeur de courant mesurée moyennée au cours du temps est une valeur efficace moyennée au cours du temps, une valeur d'amplitude moyennée au cours du temps ou une valeur de crête moyennée au cours du temps de la composante fondamentale du courant.

8. Réseau de distribution basse tension selon l'une des revendications 5 à 7, **caractérisé en ce que** :
- le au moins un dispositif de mesure de courant (17a-17e, 16a-16h) est configuré de telle sorte qu'il détermine au moins deux valeurs de courant mesurées moyennées au cours du temps et les transmet au dispositif central (24),
- parmi ces valeurs, une première valeur de courant mesurée indique le courant actif de la composante fondamentale du courant moyenné pour la durée prédéfinie, et
- parmi ces valeurs, une seconde valeur de courant mesurée indique le courant réactif de la composante fondamentale du courant moyenné pour la même durée prédéfinie.

9. Réseau de distribution basse tension selon l'une des revendications 5 à 8, **caractérisé en ce que** les dispositifs de mesure de courant (17a-17e, 16a-16h) du groupe délimitent un segment exempt de charge et de source du réseau de distribution basse tension (10).

10. Réseau de distribution basse tension selon l'une des revendications 5 à 9, **caractérisé en ce que** les dispositifs de mesure de courant (17a-17e, 16a-16h) du groupe forment leurs valeurs de courant mesurées de façon synchrone.

11. Réseau de distribution basse tension selon l'une des revendications 5 à 10, **caractérisé en ce que** les dispositifs de mesure de courant (17a-17e, 16a-16h) du groupe moyennent au cours du temps leurs valeurs de courant mesurées respectivement pour la même durée prédéfinie.

12. Réseau de distribution basse tension selon la revendication 11, **caractérisé en ce que** la durée prédéfinie est supérieure au décuple du défaut de synchronisation temporel des dispositifs de mesure de courant (17a-17e, 16a-16h).

13. Réseau de distribution basse tension selon l'une des revendications 5 à 12, **caractérisé en ce que** le dispositif central (24) est approprié pour exécuter les étapes du procédé pour constituer des informations de topologie selon l'une des revendications 1 et 2.
